Europäisches Patentamt

European Patent Office

Office européen des brevets

(19)

(11) Veröffentlichungsnummer: **0 413 404 A2**

# (12) EUROPÄISCHE PATENTANMELDUNG

(21) Anmeldenummer: 90250205.3

(22) Anmeldetag: 09.08.90

(51) Int. Cl.⁵: **H03B 23/00**

(30) Priorität: 17.08.89 DD 331882

(43) Veröffentlichungstag der Anmeldung:
20.02.91 Patentblatt 91/08

(84) Benannte Vertragsstaaten:
AT CH DE DK FR GB LI

(71) Anmelder: DEUTSCHE POST
Zentrum für Funkdienste, Agastrasse 16
O-1199 Berlin(DE)

(72) Erfinder: Jahne, Helmut
Georg-Blank-Strasse 19
O-1055 Berlin(DE)
Erfinder: Wüstenhagen, Ulf
Wilhelm-Pieck-Strasse 225
O-1040 Berlin(DE)

(54) **Durchstimmbarer Oszillator.**

(57) Frequenzdekade - Niederfrequenzbereich - Phasenlage - akustisch - Meßgerät -digital - Speicher - Durchstimmrate - Durchstimmcharakteristik - Sinusgenerator

Die Erfindung bezieht sich auf einen durchstimmbaren Oszillator, der über mehrere Frequenzdekaden des Niederfrequenzbereiches durchstimmbar ist und dessen Phasenlage jederzeit exakt bestimmbar ist. Bevorzugtes Anwendungsgebiet sind akustische Meßgeräte nach dem Verfahren der Time Delay Spectrometry (TDS). Die Folgeschaltung von Taktgenerator, programmierbarem Taktteiler, Tabellenadreßzähler, Sinustabelle und Digital-Analog-Wandler sowie die Verbindung von Speicheradreßzähler und Speicher wird durch die Erfindung zur Verringerung des Speicherbedarfs und freier Wählbarket der Zeitabhängigkeit der Durchstimmrate durch einen Teilersteuerzähler, einen Rückwärtszähler und einen Vor- Rückwärtszähler derart verändert, daß die Speichergröße unabhängig von der Zeitdauer wird, mit der der durchstimmbare Oszillator arbeitet.

*FIG. 2*

# DURCHSTIMMBARER OSZILLATOR

## Anwendungsgebiet der Erfindung

Der durchstimmbare Oszillator läßt bei Oszillatoren, die über mehrere Frequenzdekaden durchstimmbar sind und bei denen die Phasenlage zu jedem Zeitpunkt exakt bestimmbar ist. Die Anwendung erfolgt vorzugsweise in akustischen Meßgeräten, die nach dem Verfahren der Time Delay Spectrometry (TDS) arbeiten.

## Charakteristik des bekannten Standes der Technik

Geräte zur Messung von akustischen Größen nach dem TDS-Verfahren verwenden zwei Oszillatoren, von denen der erste zur Erzeugung eines auszusendenden Tones verwendet wird und der zweite zum Herausfiltern aller Signalantelle des Signalaufnehmers (Meßmikrofon), die die gleiche Frequenz und Phasenlage besitzen, wie sie der zweite Oszillator erzeugt. Frequenz und Phase beider Oszillatoren müssen bis auf einen Zeitversatz, der der akustischen Laufzeit des Signals entspricht, übereinstimmen.

Bekannt ist, derartige Sinussignale auf analogem Weg durch Mischen aus hochfrequenten Signalen zu erzeugen, wobei das Signal eines hochfrequenten, linear mit der Zeit durchstimmbaren Oszillators mit den Signalen zweier unterschiedlicher in der Frequenz unveränderlichen Oszillatoren gemischt wird. Die beiden niederfrequenten Mischprodukte stellen hierbei die Signale der beiden Genaratoren dar. (Brüel & Kjaer, Master Catalogue 1986)

Nachteilig bei analog gesteuerten durchstimmbaren Oszillatoren ist die geringe erreichbare Genauigkeit der Phasenlage zweier Oszillatoren, da diese von der zeitlichen Linearität der Frequenzveränderung des jeweiligen durchstimmbaren Oszillators abhängt. Die Genauigkeit kann nur durch einen enormen Bauelementeaufwand gesteigert werden. Präzisionsbauelemente sind in den Oszillatoren , Mischern und den notwendigen Filtern unerläßlich. Nachteilig ist weiterhin, daß die Durchstimmrate nur linear mit der Zeit verknüpfbar ist.

Bekannt ist weiterhin die Möglichkeit auf digitalem Weg durch eine Folge von Zahlen, die einen DA-Wandler steuern, Signale zu generieren. Werden zwei DA-Wandler zeitversetzt gestartet, so erhält man zwei identische Signale, die sich nur zeitlich unterscheiden. Da zur Ermittlung aller Signalantelle, die in Frequenz und Phase mit dem Signal eines zweiten Oszillators übereinstimmen, bevorzugt ein phasenempfindlicher Gleichrichter verwendet wird, werden zur Steuerung des phasenempfindlichen Gleichrichters nur die Nulldurchgänge und die Extremwerte der sinusförmigen Schwingungen des zweiten Generators benötigt. Um diese Punkte genau zu bestimmen und um den Einsatz einer Sinustabelle für den ersten Oszillator zu ermöglichen, müssen beide Oszillatoren mit einer variablen, ein ganzzahliges Vielfaches der Signalfrequenz betragenden, Abtastfrequenz arbeiten.

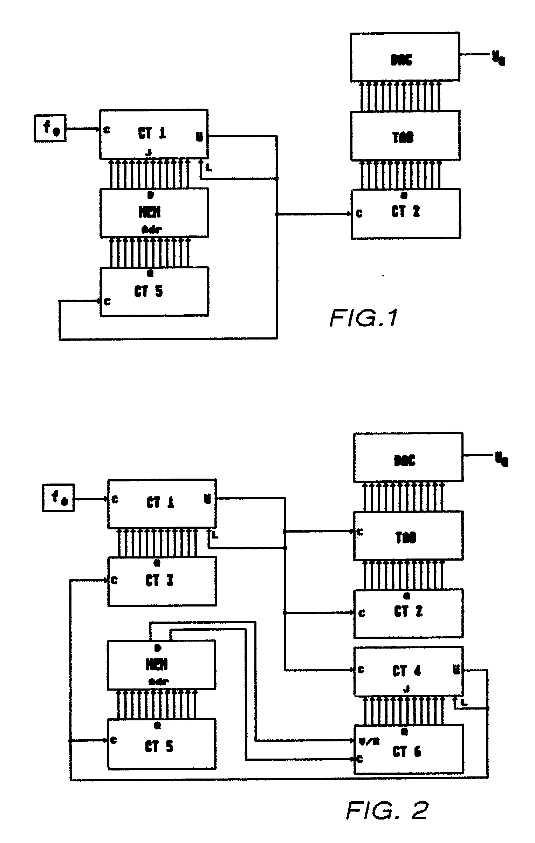

Allgemein bekannt ist das Ablegen einer Folge von Zeitdifferenzen zwischen den einzelnen Abtastwerten in Speichern, wie es in der Fig.1 dargestellt ist. Die dem Stand der Technik entsprechende Fig.1 enthält den Festfrequenzgenerator $f_0$, der einen Takt erzeugt, den programmierbaren Taktteiler $CT_1$, den Tabellenadreßzähler $CT_2$, der die Adressen für die Sinustabelle TAB erzeugt, den Digital-Analog-Wandler DAC, der eine der Sinustabelle entsprechende analoge Ausgangsspannung $U_a$ erzeugt, den Speicheradreßzähler $CT_5$ und den Speicher MEM, der die Folge aller Teilerverhältnisse enthält.

Die Folge von Zeitdifferenzen kann ebenfalls durch einen schnellen Prozessor in Echtzeit berechnet werden, wie das aus DE-OS 28 31 739, DE-OS 31 24 924 und anderen bekannt ist. Weiterhin kann diese Folge von Zeitdifferenzen durch eine Schaltungsanordnung, bestehend aus Multiplizierern und Flip-Flops, wie in US-PS 4,217,655 beschrieben, speziell für einen linear durchstimmbaren Oszillator erzeugt werden.

Bedingt durch das TDS-Meßprinzip erhöht sich die erreichbare Auflösung im Frequenzbereich bei Verringerung der Durchstimmrate des Oszillators. Eine verringerte Durchstimmrate des Oszillators erhöht die erforderliche Meßzeit und fordert eine größere Anzahl an zu erzeugenden Zeitdifferenzen.

Nachteilig bei digital durchstimmbaren Oszillatoren ist der enorm große Speicherbedarf, der bei wenigen Munuten Betriebszeit des Oszillators bereits mehr als 100 Megabit beträgt, wenn keine Beschränkung auf eine lineare Durchstimmrate des Oszillators erfolgt. Bei Verwendung von Arithmetikprozessoren ergibt sich eine unzureichende Geschwindigkeit und Genauigkeit der Ermittlung der Zeitdifferenzen, wodurch nicht der gesamte Niederfrequenzbereich von derartigen Oszillatoren durchgestimmt werden kann und immer nur kurzzeitige und damit mit einer geringen Frequenzauflösung behaftete Messungen erfolgen können.

## Ziel der Erfindung

Das Ziel der Erfindung ist die Vermeidung der Nachteile des analogen Oszillators, wie schlechte Reproduzierbarkeit der Einstellparameter ohne Verwendung von Präzisionsbaulementen und die Beschränkung auf eine lineare Durchstimmrate. Das Ziel ist andererseits die Vermeidung der Nachtelle digitaler Oszillatoren wie hohe Kosten, geringe Genauigkeit bzw. mangelnder Vielseitigkeit beim Einsatz.

## Darlegung des Wesens der Erfindung

Die Aufgabe der Erfindung besteht darin, die Folge der Zeitdifferenzen zwischen den einzelnen Abtastwerten in solcher Weise zu erzeugen, daß der durchstimmbare Oszilator einen geringen Spreicherbedarf hat, ohne spezielle Prozessoren auskommmt, den gesamten Niederfrequenzbereich überdeckt, lange Signale erzeugt und eine frei wählbare Abhängigkeit der Durchstimmrate von der Zeit gestattet.

Erfindungsgemäß wird die Aufgabe, ausgehend von der Folgeschaltung eines Taktgenerators, eines programmierbaren Taktteilers, eines Tabellenadreßzählers, einer Sinustabelle und eines Digital-Analog-Wandlers sowie der Verbindung der Ausgänge eines Speicheradreßzählers mit den Adreßeingängen eines Speichers, dadurch gelöst, daß ein Teilersteuerzähler, ein Rückwärtszähler und ein Vor-Rückwärtszähler derart angeordnet sind, daß der Takteingang des Rückwärtszählers mit dem Ausgang des Taktteilers verbunden ist, der Übertragsausgang des Rückwärtszählers mit seinem Parallelladeeingang , mit dem Takteingang des Speicheradreßzählers und mit dem Takteingang des Teilersteuerzählers verbunden ist, daß die Datenausgänge des Speichers mit den Takt- und Richtungseingängen des Vor- Rückwärtszählers verbunden sind, daß die Ausgänge des Vor- Rückwärtszählers mit den parallelen Eingängen des Rückwärtszählers verbunden sind und daß die Ausgänge des Teilersteuerzählers mit den Eingängen des Taktteilers verbunden sind.

Die Funktion der Schaltung beruht auf folgendem Prinzip: Der Rückwärtszähler zählt die Anzahl gleicher aufeinanderfolgender Teilerfaktoren. Der Vor- Rückwärtszähler zeigt die maximale Anzahl gleicher aufeinanderfolgender Teilerfaktoren an. Der Teilersteuerzähler dient zur Einstellung des Teilerverhältnisses des Taktteilers.

Beim langsamen Durchstimmen des Oszillators sind in einigen Frequenzbereichen aufgrund der vorgesehen Zeitauflösung durch den Taktgenerator mehrere Zeitdifferenzen gleich groß. Die Anzahl der gleichen zeitdifferenzen wird im Vor-Rückwärtszähler gespeichert. Bei jeder neu eingestellten Zeitdifferenz des Taktteilers wird die Anzahl in den Rückwärtszähler übernommen. Bei jeder vollendeten Frequenzteilung des Taktteilers wird die Anzahl, wie oft noch durch dieses Teilverhältnis geteilt werden soll, um eins vermindert und das konstant gebliebenen Teilerverhältnis aus dem Teilersteuerzähler in den Taktteiler übernommen. Wenn der Rückwärtszähler durch Null geht, wird der Teilersteuerzähler um eins verändert, wodurch sich beim nächsten Laden des Taktteilers die Zeitdifferenz um eins ändert. Außerdem wird der Speicheradreßzähler inkrementiert, wodurch die nächste Speicherzelle im Speicher angesprochen wird. Die Speicherzelle enthält ihrerseits nur die information, ob die neu eingestellte Zeitdifferenz genausooft wie die alte Zeitdifferenz als Teilervenhältnis des Taktteilers dienen soll. Dementsprechend wird der Vor-Rückwärtszähler nicht verändert, inkrementiert oder dekrementiert. Der Speicher enthält also nur zwei bit pro möglichem Teilerfaktor. Da die Anzahl der verschiedenen Teilerfaktoren nur vom Frequenzbereich und der zeitlichen Auflösung durch die Frequenz des Taktgenerators, nicht aber von der Häufigkeit, wie oft dieser Teilerfaktor verwendet wird, bestimmt wird, ist die Speichergröße unabhängig von der Zeitdauer, mit der der durchstimmbare Oszillator arbeiten soll.

## Ausführungsbeispiel

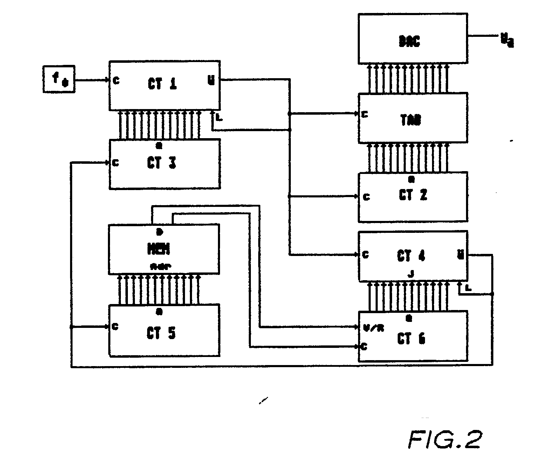

In der Fig.2 ist ein Blockschaltbild mit der Erfindung dargestellt. Der Taktgenerator $f_0$ arbeitet mit 100 MHz. Der Taktteiler $CT_1$ besteht aus drei Schaltkreisen 74 AS 161, die einen progammierbaren 12 bit-Teiler bilden. Der Taktteiler $CT_1$ wird durch den Teilersteuerzähler $CT_3$ eingestellt. Der Tabellenadreßzähler $CT_2$, bestehend aus einer synchronen Teilerkette mit sechs Schaltkreisen 74 LS 112 und getaktet durch den vom Taktteiler $CT_1$ erzeugten Abtasttaktakt, stellt die Adressen für die Sinustabelle TAB bereit. Die Sinustabelle TAB enthält zwei EPROMS U 2732, and deren Datenausgängen zur Synchronisation zwei D-Register 74 AS 374, die ebenfalls durch den Abtasttakt getaktet sind, angeschlossen sind. Die Ausgänge der D-Register sind mit den Eingängen des Digital-Analog-Wandlers DAC AD 565 verbunden, der die Ausgangsspannung $U_a$ erzeugt. Der Teilersteuerzähler $CT_3$, der Rückwärtszähler $CT_4$, der Speicheradreßzähler $CT_5$ und auch der Vor-Rückwärtszähler $CT_6$ bestehen aus jeweils drei Schaltkreisen CD 4029. Der Rückwärtszähler $CT_4$ wird vom Abtasttakt gesteuert und steuert seinerseits den Spei-

cheradreßzähler CT5 und den Teilersteuerzähler CT3. Der Speicher MEM, dessen Adreßeingänge ADR durch den Speicheradreßzähler CT5 adressiert werden, besteht aus drei CMOS-RAMs U 224 und einem Multiplexer CD 4019, der die 4-bit breiten Datenleitungen auf zwei bit multiplext. Auf diese Weise wird ein Speicher der Organisation 6k x 2 erzeugt. Die zwei bit breite Datenleitung bestehend aus den Signalen V/R und C , wird vom Vor-Rückwärtszähler CT6 ausgewertet. Die Anfangswerte der Zähler und der Inhalt der RAMs werden durch einen 16-bit PC berechnet und voreingestellt. Die Schaltung eignet sich gleichermaßen für lineare und logarithmische Durchstimmcharakteristiken des Oszillators. Der Oszillator ist im Frequenzbereich von 20 Hz bis 25 kHz durchstimmbar und kann ein Signal mit einer Länge bis zu mehreren Stunden erzeugen.

**Liste der verwendeten Bezugszeichen**

C Takteingang
C,V/R Takt- und Richtungseingänge
J Parallele Eingänge
L Parallelladeeingang
Q Ausgang
ADR Adreßeingänge
D Datenausgänge
Ü Übertragsausgang
$CT_1$ Taktteiler
$CT_2$ Tabellenadreßzähler
$CT_3$ Teilersteuerzähler
$CT_4$ Rückwärtszähler
$CT_5$ Speicheradreßzähler
$CT_6$ Vor- Rückwärtszähler
$f_0$ Taktgenerator
MEM Speicher
TAB Sinustabelle
DAC Digital-Analog-Wandler
$U_a$ Ausgangsspannung

**Ansprüche**

Durchstimmbarer Oszillator, der aus einer Folgeschaltung eines Taktgenerators, eines programmierbaren Taktteilers, eines Tabellenadreßzählers, einer Sinustabelle und eines Digital-Analog-Wandlers besteht und bei dem die Ausgänge eines Speicheradreßzählers mit den Adreßeingängen eines Speichers verbunden sind, dadurch gekennzeichnet, daß ein Teilersteuerzähler ($CT_3$), ein Rückwärtszähler ($CT_4$), ein Vor-Rückwärtszähler ($CT_6$) derart angeordnet sind, daß der Takteingang (C) des Rückwärtszählers ($CT_4$) mit dem Ausgang (Q) des Taktteilers ($CT_1$) verbunden ist, der Übertragsausgang (Ü) des Rückwärtszählers ($CT_4$) mit

seinem Parallelladeeingang (L), mit dem Takteingang (C) des Speicheradreßzählers ($CT_5$) und mit dem Takteingang (C) des Teilersteuerzählers ($CT_3$) verbunden ist, daß die Datenausgänge (D) des Speichers (MEM) mit den Takt-und Richtungseingängen (C,V/R) des Vor- Rückwärtszählers ($CT_6$) verbunden sind, daß die Ausgänge (Q) des Vor-Rückwärtszählers ($CT_6$) mit den parallelen Eingängen (J) des Rückwärtszählers ($CT_4$) verbunden sind und daß die Ausgänge (Q) des Teilersteuerzählers ($CT_3$) mit den Eingängen (J) des Taktteilers ($CT_1$) verbunden sind.

FIG.1

FIG. 2

FIG.2